(19) Europäisches Patentamt
European Patent Office
Office européen des brevets

(11) **EP 2 560 282 A1**

(12) **EUROPEAN PATENT APPLICATION**

(43) Date of publication:
**20.02.2013 Bulletin 2013/08**

(51) Int Cl.:
***H03K 17/0412*** *(2006.01)*

(21) Application number: **12156288.8**

(22) Date of filing: **21.02.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **19.08.2011  JP 2011179314** | (71) Applicant: **Kabushiki Kaisha Yaskawa Denki Kitakyushu-shi, Fukuoka 806-0004 (JP)**<br><br>(72) Inventor: **Kaneda, Heiji Fukuoka, 806-0004 (JP)**<br><br>(74) Representative: **Viering, Jentschura & Partner Grillparzerstrasse 14 81675 München (DE)** |

(54) **Gate drive circuit**

(57)    This gate drive circuit (11) includes a P-type field effect transistor (12), an N-type field effect transistor (13), and a diode (14, 15), and the diode is so formed as to shift a voltage applied to at least either a gate of the P-type field effect transistor or a gate of the N-type field effect transistor to a side of a threshold voltage of the gate.

## FIG.2

### FIRST EMBODIMENT

**Description**

BACKGROUND OF THE INVENTION

Field of the Invention

The present invention relates to a gate drive circuit.

Description of the Related Art

A gate drive circuit including a P-type field effect transistor and an N-type field effect transistor is known in general.

Japanese Patent Laying-Open No. 2006-340088 discloses a signal drive circuit (gate drive circuit) including a PMOS transistor (P-type field effect transistor) and an NMOS transistor (N-type field effect transistor), the drain of which is connected to the drain of the PMOS transistor. In this signal drive circuit, the gate of the PMOS transistor and the gate of the NMOS transistor are connected to each other, and the same voltage is applied thereto. The source of the PMOS transistor is connected to a power supply potential, and the source of the NMOS transistor is connected to a ground potential.

In the signal drive circuit disclosed in the aforementioned Japanese Patent Laying-Open No. 2006-340088, however, the same voltage is applied to the gate of the PMOS transistor and the gate of the NMOS transistor so that there is a period during which the PMOS transistor and the NMOS transistor are simultaneously in an ON-state. Thus, a short-circuit current flows from the power supply potential to the ground potential through the PMOS transistor and the NMOS transistor, whereby power consumption is increased while speeding up of switching is prevented.

SUMMARY OF THE INVENTION

The present invention has been proposed in order to solve the aforementioned problem, and an object of the present invention is to provide a gate drive circuit capable of suppressing increase in power consumption due to a short-circuit current generated in a period during which a P-type field effect transistor and an N-type filed effect transistor are simultaneously in an ON-state and allowing a power element to perform high-speed switching.

In order to attain the aforementioned object, a gate drive circuit according to an aspect of the present invention that is a gate drive circuit driving a gate of a switching element includes a P-type field effect transistor, an N-type field effect transistor connected in series with the P-type field effect transistor, and a diode connected to at least either a gate of the P-type field effect transistor or a gate of the N-type field effect transistor and connected to a power source, while the diode is so formed as to shift a voltage applied to at least either the gate of the P-type field effect transistor or the gate of the N-type field effect transistor to a side of a threshold voltage of at least either the gate of the P-type field effect transistor or the gate of the N-type field effect transistor. The threshold voltage denotes a gate voltage required for a field effect transistor (FET) to carry a drain current. The threshold voltage of the P-type field effect transistor is a gate voltage from a positive power supply voltage, and the threshold voltage of the N-type field effect transistor is a gate voltage measured from a reference supply (0 V) side power supply voltage.

In the gate drive circuit according to the aspect, as hereinabove described, the diode shifts the voltage applied to at least either the gate of the P-type field effect transistor or the gate of the N-type field effect transistor to the side of the threshold voltage of at least either the gate of the P-type field effect transistor or the gate of the N-type field effect transistor, whereby a difference between the voltage applied to at least either the gate of the P-type field effect transistor or the gate of the N-type field effect transistor and the threshold voltage of at least either the gate of the P-type field effect transistor or the gate of the N-type field effect transistor is reduced. Thus, a period from the time when the voltage applied to the gate starts increasing (or starts decreasing) to the time when at least either the P-type field effect transistor or the N-type field effect transistor is switched from an ON-state to an OFF-state (or from an OFF-state to an ON-state) can be reduced. Consequently, a period during which the P-type field effect transistor and the N-type filed effect transistor both are simultaneously in an ON-state can be reduced, and hence increase in power consumption due to a short-circuit current can be suppressed while a power element is allowed to perform high-speed switching.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a block diagram of a power converter (motor control apparatus) according to a first embodiment of the present invention;

Fig. 2 is a circuit diagram of a gate drive circuit of the power converter (motor control apparatus) according to the first embodiment of the present invention;

Fig. 3 is a voltage waveform diagram for illustrating the operation of the gate drive circuit of the power converter (motor control apparatus) according to the first embodiment of the present invention;

Fig. 4 is a circuit diagram of a gate drive circuit according to a comparative example;

Fig. 5 is a circuit diagram of a gate drive circuit of a power converter (motor control apparatus) according to a second embodiment of the present invention;

Fig. 6 is a voltage waveform diagram for illustrating the operation of the gate drive circuit of the power converter (motor control apparatus) according to the second embodiment of the present invention;

Fig. 7 is a diagram showing simultaneous ON-periods, power consumption, and circuit constants of the comparative example, the first embodiment, and the second embodiment obtained by simulations;

Fig. 8 is a circuit diagram of a gate drive circuit according to a first modification of the second embodiment of the present invention;

Fig. 9 is a circuit diagram of a gate drive circuit according to a second modification of the second embodiment of the present invention; and

Fig. 10 illustrates an example of replacing a Zener diode in the present invention with diodes.

DESCRIPTION OF THE EMBODIMENTS

Embodiments of the present invention are now described with reference to the drawings.

(First Embodiment)

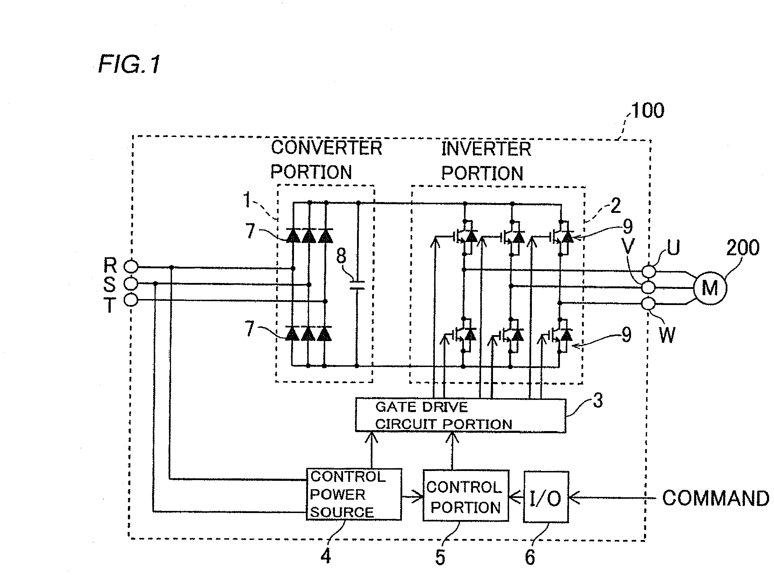

First, the structure of a motor control apparatus 100, which is an example of a power converter according to a first embodiment of the present invention, is described with reference to Fig. 1. The power converter includes one employing a gate drive circuit according to this embodiment, such as a high frequency power source or a motor drive unit.

As shown in Fig. 1, the motor control apparatus 100 according to the first embodiment includes a converter portion 1, an inverter portion 2, a gate drive circuit portion 3, a control power source 4, a control portion 5, and an input/output port (I/O) 6. The converter portion 1 is an example of a power rectifier converting an AC voltage to a DC voltage, and the inverter portion 2 is an example of the "power conversion portion" in the present invention.

A three-phase AC source is input from an R terminal, an S terminal, and a T terminal to the converter portion 1. The converter portion 1 includes a three-phase full wave rectification diode bridge and a smoothing condenser smoothing a voltage on the DC output side of the three-phase full wave rectification diode bridge. The three-phase AC source is connected to the input side of the converter portion 1, and the output of the converter portion 1 is connected to the input side of the inverter portion 2. The output of the inverter portion 2 is connected to a motor (M) 200 that is a load through a U terminal, a V terminal, and a W terminal.

The control power source 4 is connected with the R terminal and the S terminal, and a single-phase AC source is input to the control power source 4. The control power source 4 is connected to the control portion 5 and the gate drive circuit portion 3 and supplies a power source thereto. The control portion 5 is connected with the input/output port 6, and a command is externally input to the control portion 5 through the input/output port 6. The control portion 5 outputs a PWM gate drive signal to the gate drive circuit portion 3.

The converter portion 1 is provided with a full-wave rectifier circuit constituted by six diodes 7 and a smoothing condenser 8. The converter portion 1 has a function of converting AC into DC. The inverter portion 2 is provided with six switching elements 9. The switching elements 9 each are constituted by an IGBT (insulated gate bipolar transistor) and a free wheel diode.

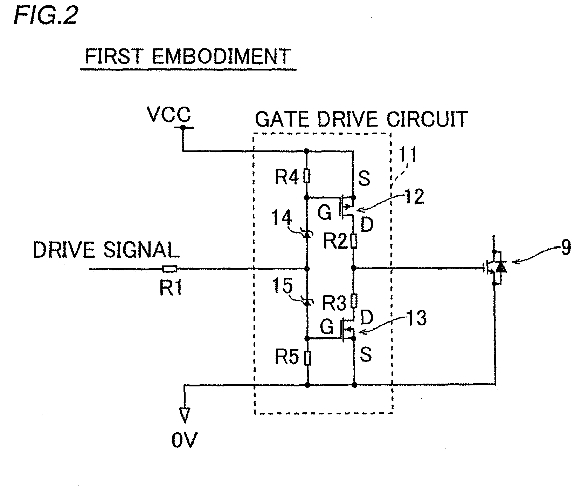

The gate drive circuit portion 3 is provided with gate drive circuits 11 (see Fig. 2) connected to the respective gates of the six switching elements 9. Fig. 2 is a circuit diagram of each gate drive circuit. Each of the gate drive circuits 11 is constituted by a PchFET 12, an NchFET 13, resistances R2, R3, R4, and R5, and two Zener diodes 14 and 15. The PchFET 12 is an example of the "P-type field effect transistor" in the present invention. The NchFET 13 is an example of the "N-type field effect transistor" in the present invention. The Zener diode 14 is an example of the "diode" and the "first diode" in the present invention. The Zener diode 15 is an example of the "diode" and the "second diode" in the present invention.

The source (S) of the PchFET 12 is connected to a power supply potential (VCC), and the drain (D) of the PchFET 12 is connected to the drain (D) of the NchFET 13 through the resistances R2 and R3. The source (S) of the NchFET 13 is connected to a ground potential (0 V) through the resistance R5. A common connecting point of the resistances R2 and R3 is connected to the gate (G) of each of the switching elements 9 of the inverter portion 2. The gate (G) of the PchFET 12 is connected to the power supply potential (VCC) through the resistance R4.

According to the first embodiment, the Zener diode 14 to shift a voltage applied to the gate (G) of the PchFET 12 to the side of the threshold voltage of the gate (G) of the PchFET 12 by increasing the voltage applied to the gate (G) of the PchFET 12 is provided between an input side into which a drive signal is input (resistance R1) and the gate (G) of the PchFET 12. Specifically, the anode of the Zener diode 14 is connected to the resistance R1. The cathode of the Zener diode 14 is connected to the gate (G) of the PchFET 12 and connected to the power supply potential (VCC) through the resistance R4. The Zener diode 14 is so selected that a Zener voltage is lower than a voltage obtained by subtracting the threshold voltage of the gate (G) of the PchFET 12 from the power supply potential (VCC).

The drain (D) of the NchFET 13 is connected to the drain (D) of the PchFET 12 through the resistances R2 and R3. The source (S) of the NchFET 13 is connected to the ground potential (0 V). According to the first embodiment, the Zener diode 15 to shift a voltage applied to the gate (G) of the NchFET 13 to the side of the threshold voltage of the gate (G) of the NchFET 13 by decreasing the voltage applied to the gate (G) of the NchFET 13 is provided between the input side into which a drive signal is input (resistance R1) and the gate (G) of the NchFET 13. Specifically, the cathode of the Zener diode 15 is connected to the resistance R1. The anode of the Zener diode 15 is connected to the gate (G) of the NchFET 13 and connected to the ground potential (0 V) through the resistance R5. The Zener diode 15 is so selected that a voltage obtained by subtracting a Zener voltage from the power supply potential (VCC) is higher than the threshold voltage of the NchFET 13. The resistance values of the resistances R1, R4, and R5 are so selected that R1 is much smaller than R4 and R5.

In order to inhibit the PchFET 12 and the NchFET 13 from being simultaneously turned on, a value obtained by adding the threshold voltage of the PchFET 12 and the threshold voltage of the NchFET 13 is preferably not less than the power supply potential (VCC). In other words, it is preferable to satisfy the following formula (1).

$$\text{(threshold voltage of PchFET 12)} + \text{(threshold voltage of NchFET 13)} \geqq \text{power supply potential (VCC)} \ldots (1)$$

However, the threshold voltages of the gates (G) of the PchFET 12 and the NchFET 13 are relatively small as compared with the power supply potential (VCC), whereby it is difficult to satisfy the state of the aforementioned formula (1) (especially a state where the equality holds). Therefore, the Zener diode 14 and the Zener diode 15 are provided as described above, whereby the PchFET 12, the NchFET 13, the Zener diode 14, and the Zener diode 15 are so selected as to satisfy the following formula (2). In other words, the PchFET 12, the NchFET 13, the Zener diode 14, and the Zener diode 15 are so selected that a value obtained by adding the threshold voltage of the PchFET 12, the threshold voltages of the Zener diode 14 and the Zener diode 15, and the threshold voltage of the NchFET 13 is not less than the power supply potential (VCC).

$$\text{(threshold voltage of PchFET 12)} + \text{(Zener voltage of Zener diode 14)} + \text{(Zener voltage of Zener diode 15)} + \text{(threshold voltage of NchFET 13)} \geqq \text{power supply potential (VCC)} \ldots (2)$$

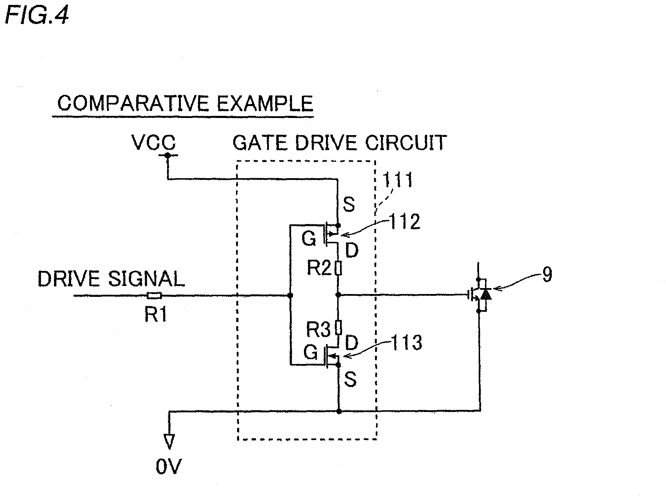

Next, the operation of the gate drive circuit 11 of the motor control apparatus 100 according to the first embodiment of the present invention is described with reference to Figs. 2 to 4 in comparison with a comparative example shown in Fig. 4 where no Zener diode is employed.

First, the structure of a gate drive circuit 111 according to the comparative example is described with reference to Fig. 4. As shown in Fig. 4, in the gate drive circuit 111 according to the comparative example, the Zener diode 14 and the Zener diode 15 of the first embodiment shown in Fig. 2 are removed, the gates (G) of the PchFET 12 and the NchFET 13 of the first embodiment shown in Fig. 2 are connected to one end of the resistance R1 into which a drive signal is input, the resistance R4 of the first embodiment shown in Fig. 2 connected between the gate (G) of the PchFET 12 and the power supply potential (VCC) is removed, and the resistance R5 of the first embodiment shown in Fig. 2 connected between the gate (G) of the NchFET 13 and the ground potential (0 V) is removed, dissimilarly to the gate drive circuit 11 of the motor control apparatus 100 according to the aforementioned first embodiment. The properties of PchFETs 12 and 112 (NchFETs 13 and 113) such as threshold voltages are equal to each other. It is assumed that the threshold voltages of the PchFETs 12 and 112 are higher than the threshold voltages of the NchFETs 13 and 113.

(Period A)

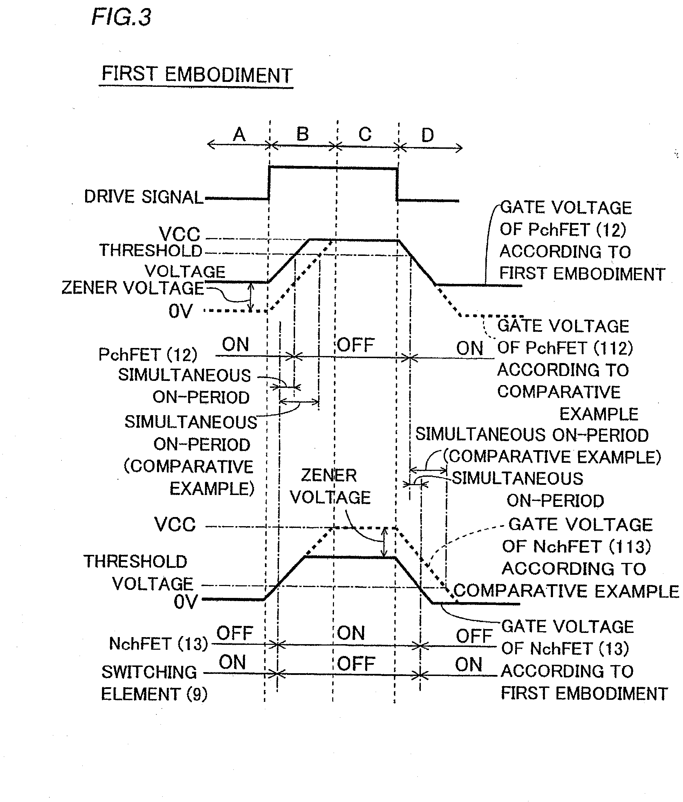

As shown in Fig. 3, a low-level (0 V) drive signal is input through the resistance R1 in a period A. According to the first embodiment, the Zener diode 14 is provided between the resistance R1 and the gate (G) of the PchFET 12 while the gate (G) of the PchFET 12 is connected to the power supply potential (VCC) through the resistance R4 so that the voltage applied to the gate (G) of the PchFET 12 becomes higher than 0 V by the Zener voltage of the Zener diode 14. On the other hand, a voltage (broken line in Fig. 3) applied to the gate (G) of the PchFET 112 is low-level (0 V) in the comparative example.

In the period A, the voltage applied to the gate (G) of the PchFET 12 according to the first embodiment (voltage higher than 0 V by the Zener voltage of the Zener diode 14) is lower than a value obtained by subtracting the threshold voltage of the gate (G) of the PchFET 12 (PchFET 112) from the power supply potential (VCC) due to the aforementioned selection of the Zener diode 14. The voltage applied to the gate (G) of the PchFET 112 according to the comparative example is 0 V and lower than the value obtained by subtracting the threshold voltage of the gate (G) of the PchFET 12 (PchFET 112) from the power supply potential (VCC). Therefore, the PchFET 12 according to the first embodiment and the PchFET 112 according to the comparative example are turned on. Thus, the power supply potential (VCC) is applied to the gate of each of the switching elements 9 of the inverter portion 2 (see Fig. 1) so that the switching elements 9 are turned on.

A voltage of the ground potential (0 V) is applied to the gate (G) of the NchFET 13 according to the first embodiment through the resistance R5. On the other hand, a low-level (0 V) voltage is applied to the gate (G) of the NchFET 113 according to the comparative example through the resistance R1. Therefore, the voltage applied to the gate (G) of the NchFET 113 is lower than the threshold voltage of the NchFET 13 (NchFET 113), whereby the NchFET 13 according to the first embodiment and the NchFET 113 according the comparative example are turned off.

(Period B)

In a period B, the drive signal input through the resistance R1 is changed from a low level (0 V) to a high level (VCC). Thus, stray capacitance between the gate and the source of the PchFET is gradually discharged through the resistance R1, and hence the voltages applied to the gate (G) of the PchFET 12 according to the first embodiment and the gate (G) of the PchFET 112 according to the comparative example are gradually increased. Consequently, the PchFET 12 according to the first embodiment and the PchFET 112 according to the comparative example are turned off when the voltages applied to the gates (G) each become equal to the value obtained by subtracting the threshold voltage from the power supply potential (VCC). In the period A, the voltage higher than 0 V by the Zener voltage of the Zener diode 14 is applied to the PchFET 12 according to the first embodiment, and hence the voltage applied to the gate (G) of the PchFET 12 according to the first embodiment reaches the threshold voltage faster than the voltage applied to the gate (G) of the PchFET 112 according to the comparative example. Consequently, the PchFET 12 according to the first embodiment is turned off faster than the PchFET 112 according to the comparative example. Then, a voltage of VCC is applied to the gate (G) of the PchFET 12 through the resistance R4 when the voltage applied to the gate (G) of the PchFET 12 according to the first embodiment becomes equal to VCC. On the other hand, a high-level (VCC) voltage is applied to the gate (G) of the PchFET 112 according to the comparative example through the resistance R1.

Furthermore, stray capacitance between the gate and the source of the NchFET is gradually charged through the resistance R1, and hence the voltages applied to the gate (G) of the NchFET 13 according to the first embodiment and the gate (G) of the NchFET 113 according to the comparative example are gradually increased. When the voltages applied to the gate (G) of the NchFET 13 according to the first embodiment and the gate (G) of the NchFET 113 according to the comparative example each become equal to the threshold voltage, the NchFET 13 according to the first embodiment and the NchFET 113 according to the comparative example are turned on. Thus, the ground potential (0 V) is applied to the gates of the switching elements 9 of the inverter portion 2 (see Fig. 1) so that the switching elements 9 are turned off.

Then, the voltages applied to the gate (G) of the NchFET 13 according to the first embodiment and the gate (G) of the NchFET 113 according to the comparative example each become higher than the threshold voltage. The Zener diode 15 is provided between the resistance R1 and the gate (G) of the NchFET 13 while the gate (G) of the NchFET 13 is connected to the ground potential (0 V) through the resistance R5 so that a voltage lower than the power supply potential (VCC) by the Zener voltage of the Zener diode 15 is applied to the gate (G) of the NchFET 13 according to the first embodiment. On the other hand, the power supply potential (VCC) is applied to the gate (G) of the NchFET 113 according to the comparative example through the resistance R1.

In the first embodiment, the PchFET 12 and the NchFET 13 both are in an ON-state during a period from the time when the NchFET 13 is turned on to the time when the PchFET 12 is turned off. Similarly, also in the comparative example, the PchFET 112 and the NchFET 113 both are in an ON-state during a period from the time when the NchFET 113 is turned on to the time when the PchFET 112 is turned off. As described above, the PchFET 12 according to the first embodiment is turned off faster than the PchFET 112 according to the comparative example, and hence a period during which the PchFET 12 and the NchFET 13 according to the first embodiment both are in an ON-state (simultaneous ON-period) is shorter than a period during which the PchFET 112 and the NchFET 113 according to the comparative example both are in an ON-state.

(Period C)

[0031]    - In a period C, a high-level (VCC) drive signal is input through the resistance R4 subsequent to the period B. Thus, a voltage of VCC is applied to the gate (G) of the PchFET 12 according to the first embodiment, and the voltage of VCC is applied also to the gate (G) of the PchFET 112 according to the comparative example. Therefore, the PchFET 12 according to the first embodiment and the PchFET 112 according to the comparative example remain in an OFF-state.

The voltage lower than VCC by the Zener voltage of the Zener diode 15 is applied to the gate (G) of the NchFET 13 according to the first embodiment, and the voltage of VCC is applied to the gate (G) of the NchFET 113 according to the comparative example through the resistance R1. Therefore, the NchFET 12 according to the first embodiment and the NchFET 112 according to the comparative example remain in an OFF-state. Consequently, the ground potential (0 V) is applied to the gates of the switching elements 9 of the inverter portion 2 (see Fig. 1) so that the switching elements 9 remain in an OFF-state.

(Period D)

In a period D, the drive signal input through the resistance R1 is changed from the high level (VCC) to the low level (0 V). Thus, the stray capacitance between the gate (G) and the source (S) of the PchFET 12 according to the first embodiment and the stray capacitance between the gate (G) and the source (S) of the PchFET 112 according to the comparative example each are gradually charged through the resistance R1. Therefore, the voltages applied to the gate (G) of the PchFET 12 according to the first embodiment and the gate (G) of the PchFET 112 according to the comparative example are decreased gradually but not rapidly. When the voltages applied to the gate (G) of the PchFET 12 according to the first embodiment and the gate (G) of the PchFET 112 according to the comparative example each become lower than the voltage obtained by subtracting the threshold voltage from the power supply potential (VCC), the PchFET 12 and the PchFET 112 are changed from an OFF-state to an ON-state. Thereafter, the voltage higher than 0 V by the Zener voltage of the Zener diode 14 is applied to the gate (G) of the PchFET 12 according to the first embodiment, and the voltage of 0 V is applied to the gate (G) of the PchFET 112 according to the comparative example.

Furthermore, the stray capacitance between the gate (G) and the source (S) of the NchFET 13 according to the first embodiment is gradually discharged, and hence the voltage applied to the gate (G) of the NchFET 13 is gradually decreased from the voltage lower than the power supply potential (VCC) by the Zener voltage of the Zener diode 15. When the voltage applied to the gate (G) of the NchFET 13 becomes lower than the threshold voltage, the NchFET 13 is changed from an ON-state to an OFF-state. On the other hand, the voltage applied to the gate (G) of the NchFET 113 according to the comparative example is gradually decreased from the power supply potential (VCC). When the voltage applied to the gate (G) of the NchFET 113 becomes lower than the threshold voltage, the NchFET 113 is changed from an ON-state to an OFF-state. Then, the ground potential 0 V is applied to the gate (G) of the NchFET 13 through the resistance R5 when the voltage applied to the gate (G) of the NchFET 13 according to the first embodiment becomes zero. Furthermore, the low-level (0 V) voltage is applied to the gate (G) of the NchFET 113 according to the comparative example through the resistance R1. The voltage lower than the power supply potential (VCC) by the Zener voltage of the Zener diode 15 is applied to the NchFET 13 according to the first embodiment in the period C, and hence the voltage applied to the gate (G) of the NchFET 13 according to the first embodiment reaches the threshold voltage faster than the voltage applied to the gate (G) of the NchFET 113 according to the comparative example. Consequently, the NchFET 13 according to the first embodiment is turned off faster than the NchFET 113 according to the comparative example.

In the first embodiment, the PchFET 12 and the NchFET 13 both are in an ON-state during a period from the time when the PchFET 12 is turned on to the time when the NchFET 13 is turned off. Similarly, also in the comparative example, the PchFET 112 and the NchFET 113 both are in an ON-state during a period from the time when the PchFET 112 is turned on to the time when the NchFET 113 is turned off. As described above, the NchFET 13 according to the first embodiment is turned off faster than the NchFET 113 according to the comparative example, and hence the period during which the PchFET 12 and the NchFET 13 according to the first embodiment both are in an ON-state (simultaneous ON-period) is shorter than the period during which the PchFET 112 and the NchFET 113 according to the comparative example both are in an ON-state.

According to the first embodiment, as hereinabove described, the Zener diodes 14 and 15 shift the voltages applied to the gates (G) of the PchFET 12 and the NchFET 13 to the sides of the threshold voltages of the gates (G) of the PchFET 12 and the NchFET 13, respectively, whereby differences between the voltages applied to the gates (G) of the PchFET 12 and the NchFET 13 and the threshold voltages of the gates (G) of the PchFET 12 and the NchFET 13 are rendered small. Thus, the switching time from the ON-state to the OFF-state of the PchFET 12 after the start of increase in the voltage applied to the gate (G) can be reduced, and the switching time from the ON-state to the OFF-state of the NchFET 13 after the start of decrease in the voltage applied to the gate (G) can be reduced. Consequently, the period during which the PchFET 12 and the NchFET 13 both are in an ON-state can be reduced, and hence increase in power consumption due to a short-circuit current can be suppressed while the switching elements 9 are allowed to perform high-speed switching.

According to the first embodiment, as hereinabove described, the value obtained by adding the threshold voltage of the PchFET 12, the Zener voltages of the Zener diodes 14 and 15, and the threshold voltage of the NchFET 13 is not less than the power supply potential (VCC). Thus, the period during which the PchFET 12 and the NchFET 13 are simultaneously in an ON-state can be rendered substantially zero.

(Second Embodiment)

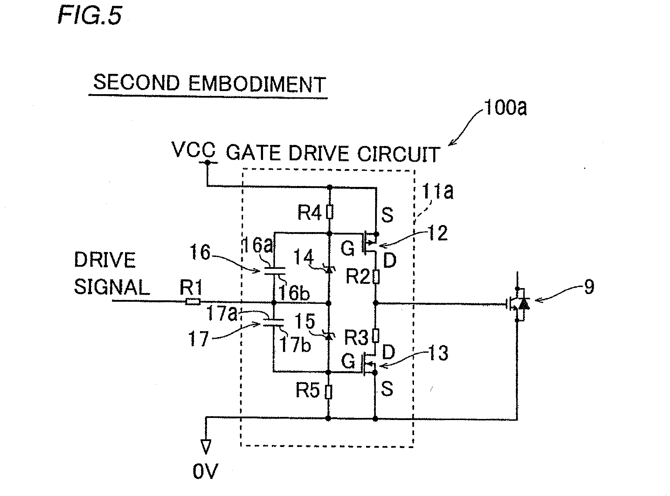

First, a gate drive circuit 11a of a motor control apparatus 100a according to a second embodiment is described with reference to Fig. 5. In this second embodiment, a condenser 16 is provided between an input side into which a drive signal is input and a PchFET 12, and a condenser 17 is provided between the input side into which a drive signal is input and an NchFET 13. The condensers 16 and 17 are examples of the "first condenser" and the "second condenser" in the present invention, respectively.

As shown in Fig. 5, in the gate drive circuit 11a of the motor control apparatus 100a according to the second embodiment, the condenser 16 is provided in parallel with a Zener diode 14 between the input side into which a drive signal is input (resistance R1) and the PchFET 12. The condenser 16 has a function of increasing the rate of increase in a voltage applied to a gate (G) when the PchFET 12 shifts from an ON-state to an OFF-state. An electrode 16a of the condenser 16 is connected to a resistance R4, the Zener diode 14, and the gate (G) of the PchFET 12 while an electrode 16b thereof is connected to the resistance R1.

According to the second embodiment, the condenser 17 is provided in parallel with a Zener diode 15 between the input side into which a drive signal is input and the NchFET 13. The condenser 17 has a function of increasing the rate of decrease in a voltage applied to a gate (G) when the NchFET 13 shifts from an ON-state to an OFF-state. An electrode 17a of the condenser 17 is connected to the resistance R1 while an electrode 17b thereof is connected to a resistance R5, the Zener diode 15, and the gate (G) of the NchFET 13. The remaining structure of the gate drive circuit 11a according to the second embodiment is similar to that of the gate drive circuit 11 according to the first embodiment.

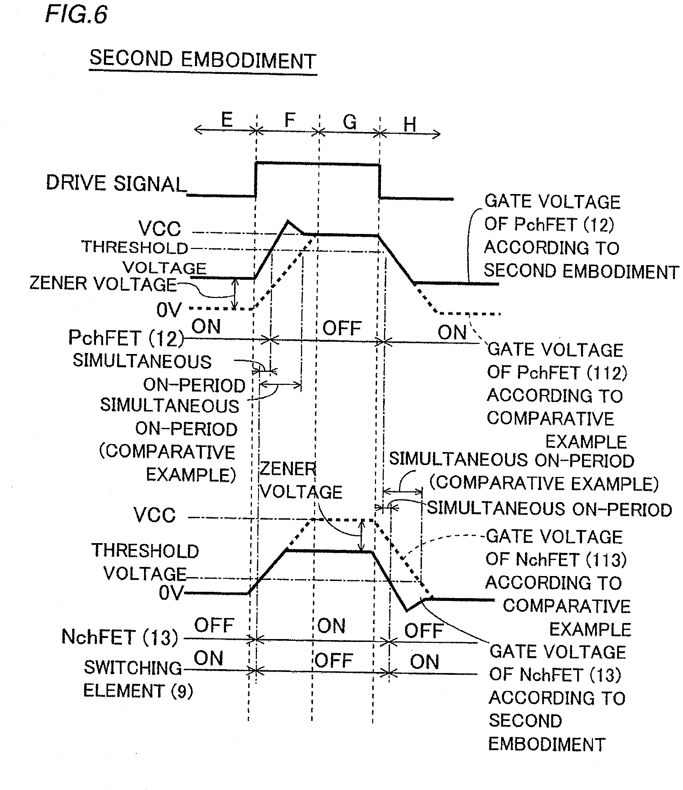

Next, the operation of the gate drive circuit 11a of the motor control apparatus 100a according to the second embodiment of the present invention is described with reference to Fig. 6 in comparison with the comparative example shown in Fig. 4.

(Period E)

As shown in Fig. 6, a low-level (0 V) drive signal is input through the resistance R1 in a period E. According to the second embodiment, a voltage higher than 0 V by the Zener voltage of the Zener diode 14 is applied to the gate (G) of the PchFET 12, similarly to the aforementioned first embodiment. On the other hand, a voltage (broken line in Fig. 6) applied to the gate (G) of the PchFET 112 is low-level (0 V) in the comparative example. As described above, the Zener voltage of the Zener diode 14 is lower than a value obtained by subtracting the threshold voltage of the gate (G) of the PchFET 12 from a power supply potential (VCC). Consequently, the PchFET 12 (PchFET 112) is turned on. The condenser 16 according to the second embodiment is charged with the Zener voltage of the Zener diode 14. At this time, stray capacitance between the gate and the source of the PchFET 12 is charged with the power supply potential (VCC) and the Zener voltage of the Zener diode 14.

A voltage of 0 V is applied to the gate (G) of the NchFET 13 according to the second embodiment through the resistance R5. Similarly, a low-level (0 V) voltage is applied to the gate (G) of the NchFET 113 according to the comparative example through the resistance R1. Consequently, the NchFETs 13 and 113 are turned off. A potential difference between the electrodes 17a and 17b of the condenser 17 is 0 V.

(Period F)

In a period F, the drive signal input through the resistance R1 is changed from a low level (0 V) to a high level (VCC). At this time, stray capacitance between the gate and the source of the PchFET is gradually discharged, and hence the voltages applied to the gate (G) of the PchFET 12 according to the second embodiment and the gate (G) of the PchFET 112 according to the comparative example (see Fig. 4) are gradually increased. The stray capacitance between the gate and the source of the PchFET 12 is discharged through two discharge routes of a discharge route through the R1 and a discharge route through the R4. On the other hand, the stray capacitance between the gate and the source of the PchFET 112 is discharged only through a discharge route through the R1. Therefore, the stray capacitance between the gate and the source of the PchFET 12 is discharged faster than the stray capacitance between the gate and the source of the PchFET 112, and hence the rate of increase (slope) in the voltage applied to the gate (G) of the PchFET 12 is larger than the rate of increase in the voltage applied to the gate (G) of the PchFET 112 according to the comparative example. The PchFET 12 according to the second embodiment and the PchFET 112 according to the comparative example are turned off when the voltages applied to the gates (G) each become higher than a voltage (hereinafter referred to as a turn-off voltage) obtained by subtracting the threshold voltage of the gate (G) from the power supply potential (VCC). In the period E, the voltage higher than 0 V by the Zener voltage of the Zener diode 14 is applied to the PchFET 12 according to the second embodiment while the rate of increase (slope) in the applied voltage is increased, and hence the voltage applied to the gate (G) of the PchFET 12 according to the second embodiment reaches the turn-off voltage faster than the voltage applied to the gate (G) of the PchFET 112 according to the comparative example. Consequently, the PchFET 12 according to the second embodiment is turned off faster than the PchFET 112 according to the comparative example. Then, the voltage applied to the gate (G) of the PchFET 12 according to the second embodiment is gradually increased. In general, charges accumulated in the stray capacitance between the gate and the source of the PchFET 12 become zero faster than charges accumulated in the condenser 16 due to the magnitude of capacitance, and at this time, the voltage applied to the PchFET 12 is the power supply potential (VCC). Then, only the condenser 16 is discharged, but the stray capacitance between the gate and the source of the PchFET 12 is charged with this discharge current in a polarity opposite to a polarity at the time of discharge. Thus, the voltage applied to the gate (G) of the PchFET 12 becomes higher than the power supply potential (VCC). At this time, the discharge current of the condenser 16 separately flows into the resistance R4 and the stray capacitance between the gate and the source of the PchFET 12. The current flowing into the resistance R4 is increased in proportion to the charging voltage of the stray capacitance between the gate and the source of the PchFET 12. On the other hand, the discharge current of the condenser 16 decreases as the discharge proceeds. Therefore, the current flowing into the resistance R4 and the discharge current of the condenser 16 become equal to each other at some point. At this time, the charging current of the stray capacitance between the gate and the source of the PchFET 12 is zero, and the value of the voltage applied to the gate (G) of the PchFET 12 is peak. Thereafter, the discharge currents of both the condenser 16 and the stray capacitance between the gate and the source of the PchFET 12 flow into the resistance R4, and the voltage applied to the gate (G) of the PchFET 12 is gradually decreased. When both the condenser 16 and the stray capacitance between the gate and the source of the PchFET 12 are completely discharged, the voltage applied to the gate (G) of the PchFET 12 becomes the power supply potential (VCC). On the other hand, the voltage applied to the gate (G) of the PchFET 112 according to the comparative example is gradually increased to become the power supply potential (VCC).

The voltages applied to the gate (G) of the NchFET 13 according to the second embodiment and the gate (G) of the NchFET 113 according to the comparative example are gradually increased similarly to the voltage applied to the gate (G) of the PchFET 12. When the voltages applied to the gate (G) of the NchFET 13 according to the second embodiment and the gate (G) of the NchFET 113 according to the comparative example each become equal to the threshold voltage thereof, the NchFET 13 according to the second embodiment and the NchFET 113 according to the comparative example are turned on.

A ground potential (0 V) is applied to the gates of switching elements 9 of an inverter portion 2 (see Fig. 1) so that the switching elements 9 are turned off. Then, the voltage applied to the gate (G) of the NchFET 13 is so gradually increased as to become a voltage lower than the power supply potential (VCC) by the Zener voltage of the Zener diode 15. The voltage applied to the gate (G) of the NchFET 113 according to the comparative example becomes the power supply potential (VCC).

As described above, the PchFET 12 according to the second embodiment is turned off faster than the PchFET 112 according to the comparative example, and hence a period during which the PchFET 12 and the NchFET 13 according to the second embodiment both are in an ON-state (simultaneous ON-period) is shorter than the period during which the PchFET 112 and the NchFET 113 according to the comparative example both are in an ON-state.

(Period G)

In a period G, a high-level (VCC) drive signal is input through the resistance R1 subsequent to the period F. Thus, the PchFET 12 according to the second embodiment and the PchFET 112 according to the comparative example remain in an OFF-state. The NchFET 13 according to the second embodiment and the NchFET 113 according to the comparative example remain in an ON-state.

(Period H)

In a period H, the drive signal input through the resistance R1 is changed from the high level (VCC) to the low level (0 V). Thus, the voltages applied to the gate (G) of the PchFET 12 according to the second embodiment and the gate (G) of the PchFET 112 according to the comparative example are gradually decreased. When the voltages applied to the gate (G) of the PchFET 12 according to the second embodiment and the gate (G) of the PchFET 112 according to the comparative example each become equal to a voltage (hereinafter referred to as a turn-on voltage) obtained by subtracting the threshold voltage of the gate (G) from the power supply potential (VCC), the PchFET 12 according to the second embodiment and the PchFET 112 according to the comparative example are turned on. Then, the voltage higher than 0 V by the Zener voltage of the Zener diode 14 is applied to the gate (G) of the PchFET 12 according to the second embodiment, and the voltage of 0 V is applied to the gate (G) of the PchFET 112 according to the comparative example.

Furthermore, stray capacitance between the gate (G) and the source (S) of the NchFET 13 according to the second embodiment and the stray capacitance between the gate (G) and the source (S) of the NchFET 113 according to the comparative example each are gradually discharged through the resistance R1, and hence the voltages applied to the gate (G) of the NchFET 13 according to the second embodiment and the gate (G) of the NchFET 113 according to the comparative example are gradually decreased. At this time, similarly to the PchFET 12 in the period F, more discharge currents flowing into the resistance R5 are added than in the comparative example, and hence the rate of increase (slope) in the voltage applied to the gate (G) of the NchFET 13 is larger than the rate of increase in the voltage applied to the gate (G) of the NchFET 113 according to the comparative example. When the voltages applied to the gate (G) of the NchFET 13 according to the second embodiment and the gate (G) of the NchFET 113 according to the comparative example each become lower than the threshold voltage of the gate (G), the NchFET 13 according to the second embodiment and the NchFET 113 according to the comparative example are turned off. Then, the voltage applied to the gate (G) of the NchFET 13 according to the second embodiment is gradually increased. In general, charges accumulated in the stray capacitance between the gate and the source of the NchFET 13 become zero faster than charges accumulated in the condenser 17 due to the magnitude of capacitance, and at this time, the voltage applied to the NchFET 13 is low-level (0 V). Then, only the condenser 17 is discharged, but the stray capacitance between the gate and the source of the NchFET 13 is charged with this discharge current in a polarity opposite to a polarity at the time of discharge. Thus, the voltage applied to the gate (G) of the NchFET 13 becomes lower than the low level (0 V). At this time, the discharge current of the condenser 17 separately flows into the resistance R5 and the stray capacitance between the gate and the source of the NchFET 13. The current flowing into the resistance R5 is increased in proportion to the charging voltage of the stray capacitance between the gate and the source of the NchFET 13. On the other hand, the discharge current of the condenser 17 decreases as the discharge proceeds. Therefore, the current flowing into the resistance R5 and the discharge current of the condenser 17 become equal to each other at some point. At this time, the charging current of the stray capacitance between the gate and the source of the NchFET 13 is zero, and the value of the voltage applied to the gate (G) of the NchFET 13 is the lowest. Thereafter, the discharge currents of both the condenser 17 and the stray capacitance between the gate and the source of the NchFET 13 flow into the resistance R5, and the voltage applied to the gate (G) of the NchFET 13 is gradually increased. When both the condenser 17 and the stray capacitance between the gate and the source of the NchFET 13 are completely discharged, the voltage applied to the gate (G) of the NchFET 13 becomes low-level (0 V). On the other hand, the voltage applied to the gate (G) of the NchFET 113 according to the comparative example is gradually decreased to become low-level (0 V). The voltage lower than the power supply potential (VCC) by the Zener voltage of the Zener diode 15 is applied to the NchFET 13 according to the second embodiment in the period G while the rate of decrease in the voltage applied to the NchFET 13 according to the second embodiment is larger than the rate of decrease in the voltage applied to the NchFET 113 according to the comparative example, and hence the voltage applied to the gate (G) of the NchFET 13 according to the second embodiment reaches the threshold voltage faster than the voltage applied to the gate (G) of the NchFET 113 according to the comparative example. Consequently, the NchFET 13 according to the second embodiment is turned off faster than the NchFET 113 according to the comparative example.

As described above, the NchFET 13 according to the second embodiment is turned off faster than the NchFET 113 according to the comparative example, and hence the period during which the PchFET 12 and the NchFET 13 according to the second embodiment both are in an ON-state (simultaneous ON-period) is shorter than the period during which the PchFET 112 and the NchFET 113 according to the comparative example both are in an ON-state.

According to the second embodiment, as hereinabove described, the period during which the PchFET 12 and the NchFET 13 both are in an ON-state can be reduced. Consequently, increase in power consumption due to a short-circuit current can be further suppressed.

(Simulation)

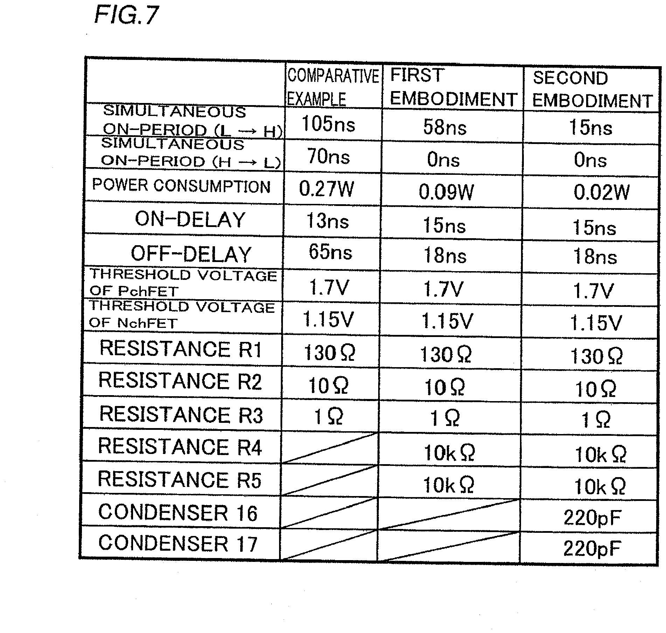

Simulations of power consumption of the gate drive circuits according to the comparative example (see Fig. 4), the first embodiment (see Fig. 2), and the second embodiment (see Fig. 5) are now described with reference to Fig. 7.

As conditions of the simulations, a low-level voltage (0 V) and a high-level voltage (13 V) are applied to the PchFET 112 and the NchFET 113 according to the comparative example and the PchFET 12 and the NchFET 13 according to the first embodiment (second embodiment). The low-level voltage (0 V) and the high-level voltage (13 V) are alternately applied at an interval of 100 kHz. The resistance values of the resistances R1 connected to the PchFET 112 and the NchFET 113 according to the comparative example and the PchFET 12 and the NchFET 13 according to the first embodiment (second embodiment) each are 130 Ω. Furthermore, the resistance values of the resistances R2 and R3 provided between the PchFET 112 and the NchFET 113 according to the comparative example and between the PchFET 12 and the NchFET 13 according to the first embodiment (second embodiment) are 10 Ω and 1 Ω, respectively. The resistance values of the resistances R4 and R5 connected to the PchFET 12 and the NchFET 13 according to the first embodiment (second embodiment), respectively is 10 kΩ. The capacitances of the condensers 16 and 17 according to the second embodiment each are 220 pF. The threshold voltages of the PchFET 112 according to the comparative example and the PchFET 12 according to the first embodiment (second embodiment) each are 1.7 V. The threshold voltages of the NchFET 113 according to the comparative example and the NchFET 13 according to the first embodiment (second embodiment) each are 1.15 V.

When the simulations were performed under the aforementioned conditions, it was proved that the period during which the PchFET 112 and the NchFET 113 both are in an ON-state was 105 ns when the voltages applied to the PchFET 112 and the NchFET 113 shifted from a low level (0 V) to a high level (13 V) (see the period B in Fig. 3) in the gate drive circuit 111 (see Fig. 4) according to the comparative example. Furthermore, it was proved that the period during which the PchFET 112 and the NchFET 113 both are in an ON-state was 70 ns when the voltages applied to the PchFET 112 and the NchFET 113 shifted from the high level (13 V) to the low level (0 V) (see the period D in Fig. 3). Consequently, it was proved that power consumed by a short-circuit current flowing from the PchFET 112 to the NchFET 113 through the resistances R2 and R3 was 0.27 W.

It was confirmed that a period (ON-delay) from the time when the voltages applied to the PchFET 112 and the NchFET 113 start shifting from the low level (0 V) to the high level (13 V) to the time when the switching elements 9 start shifting from an ON-state to an OFF-state was 13 ns. Furthermore, it was confirmed that a period (OFF-delay) from the time when the voltages applied to the PchFET 112 and the NchFET 113 start shifting from the high level (13 V) to the low level (0 V) to the time when the switching elements 9 start shifting from the OFF-state to the ON-state was 65 ns.

It was proved that the period during which the PchFET 12 and the NchFET 13 both are in an ON-state was 58 ns when the voltages applied to the PchFET 12 and the NchFET 13 shifted from the low level (0 V) to the high level (13 V) (see the period B in Fig. 3) in the gate drive circuit 11 (see Fig. 2) according to the first embodiment. Furthermore, it was proved that the period during which the PchFET 12 and the NchFET 13 both are in an ON-state was 0 s when the voltages applied to the PchFET 12 and the NchFET 13 shifted from the high level (13 V) to the low level (0 V) (see the period D in Fig. 3). More specifically, it was confirmed that the total period during which the PchFET 12 and the NchFET 13 according to the first embodiment both are in an ON-state, which is 58 ns (= 58 ns + 0 s), was shorter than the total period during which the PchFET 112 and the NchFET 113 according to the comparative example both are in an ON-state, which is 175 ns (= 105 ns + 70 ns). In other words, it was confirmed that the gate drive circuit 11 was provided with the Zener diodes 14 and 15 so that the period during which the PchFET 12 and the NchFET 13 both are in an ON-state was reduced. Consequently, it was proved that power consumed by a short-circuit current flowing from the PchFET 12 to the NchFET 13 through the resistances R2 and R3 was 0.09 W that is smaller than that (0.27 W) in the comparative example.

It was confirmed that a period (ON-delay) from the time when the voltages applied to the PchFET 12 and the NchFET 13 start shifting from the low level (0 V) to the high level (13 V) to the time when the switching elements 9 start shifting from the ON-state to the OFF-state was 15 ns. Furthermore, it was confirmed that a period (OFF-delay) from the time when the voltages applied to the PchFET 12 and the NchFET 13 start shifting from the high level (13 V) to the low level (0 V) to the time when the switching elements 9 start shifting from the OFF-state to the ON-state was 18 ns.

It was proved that the period during which the PchFET 12 and the NchFET 13 both are in an ON-state was 15 ns when the voltages applied to the PchFET 12 and the NchFET 13 shifted from the low level (0 V) to the high level (13 V) (see the period F in Fig. 6) in the gate drive circuit 11a (see Fig. 5) according to the second embodiment. Furthermore, it was proved that the period during which the PchFET 12 and the NchFET 13 both are in an ON-state was 0 s when the voltages applied to the PchFET 12 and the NchFET 13 shifted from the high level (13 V) to the low level (0 V) (see the period H in Fig. 6). More specifically, it was confirmed that the total period during which the PchFET 12 and the NchFET 13 according to the second embodiment both are in an ON-state, which is 15 ns (= 15 ns + 0 s), was shorter than the total period during which the PchFET 112 and the NchFET 113 according to the comparative example both are in an ON-state, which is 175 ns (= 105 ns + 70 ns), and the total period during which the PchFET 12 and the NchFET 13 according to the first embodiment both are in an ON-state, which is 58 ns (= 58 ns + 0 s). In other words, it was confirmed that the gate drive circuit 11a was provided with the Zener diodes 14 and 15 and the condensers 16 and 17 so that the period during which the PchFET 12 and the NchFET 13 both are in an ON-state was further reduced. Consequently, it was proved that power consumed by a short-circuit current flowing from the PchFET 12 to the NchFET 13 through the resistances R2 and R3 was 0.02 W that is smaller than that (0.27 W) in the comparative example and that (0.09 W) in the first embodiment.

It was confirmed that a period (ON-delay) from the time when the voltages applied to the PchFET 12 and the NchFET 13 start shifting from the low level (0 V) to the high level (13 V) to the time when the switching elements 9 start shifting from the ON-state to the OFF-state was 15 ns similarly to the aforementioned first embodiment. Furthermore, it was confirmed that a period (OFF-delay) from the time when the voltages applied to the PchFET 12 and the NchFET 13 start shifting from the high level (13 V) to the low level (0 V) to the time when the switching elements 9 start shifting from the OFF-state to the ON-state was 18 ns similarly to the aforementioned first embodiment.

Although the present invention has been described and illustrated in detail, it is clearly understood that the same is by way of illustration and example only and is not to be taken by way of limitation, the spirit and scope of the present invention being limited only by the terms of the appended claims.

For example, while the Zener diode is provided both between the input side and the PchFET and between the input side and the NchFET in each of the aforementioned first and second embodiments, the present invention is not restricted to this. The Zener diode may alternatively be provided either between the input side and the PchFET or between the input side and the NchFET, for example.

While the Zener diode is provided both between the input side and the PchFET and between the input side and the NchFET in each of the aforementioned first and second embodiments, the present invention is not restricted to this. A diode other than the Zener diode may alternatively be provided both between the input side and the PchFET and between the input side and the NchFET, for example.

While the switching elements included in the inverter portion each are constituted by an IGBT and a free wheel diode in each of the aforementioned first and second embodiments, the present invention is not restricted to this. The switching elements each may alternatively be constituted by a field effect transistor and a free wheel diode, for example.

While the condenser is provided both between the input side and the PchFET and between the input side and the NchFET in the aforementioned second embodiment, the present invention is not restricted to this. The condenser may alternatively be provided either between the input side and the PchFET or between the input side and the NchFET, for example.

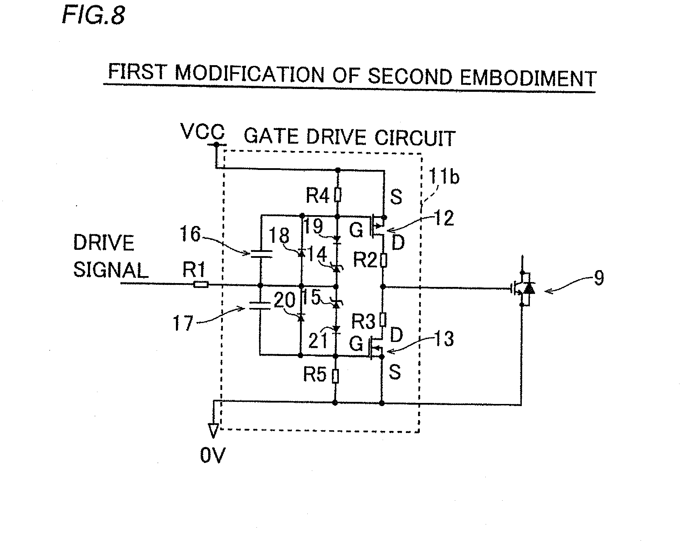

While the Zener diode and the condenser are provided in parallel with each other both between the input side and the PchFET and between the input side and the NchFET in the aforementioned second embodiment, the present invention is not restricted to this. A discharging diode 18 may alternatively be provided in parallel with a Zener diode 14 and a condenser 16 between an input side and a PchFET 12 while a backflow prevention diode 19 may alternatively be provided between the Zener diode 14 and the gate (G) of the PchFET 12 as in a gate drive circuit 11b according to a first modification of the second embodiment shown in Fig. 8, for example. Furthermore, a discharging diode 20 may alternatively be provided in parallel with a Zener diode 15 and a condenser 17 between an input side and an NchFET 13 while a backflow prevention diode 21 may alternatively be provided between the Zener diode 15 and the gate (G) of the NchFET 13. Thus, voltages can be applied to the PchFET 12 and the NchFET 13 through the discharging diode 18 and the discharging diode 20, and hence the PchFET 12 and the NchFET 13 can be easily turned on/off even if the capacitances of the PchFET 12 and the NchFET 13 are increased.

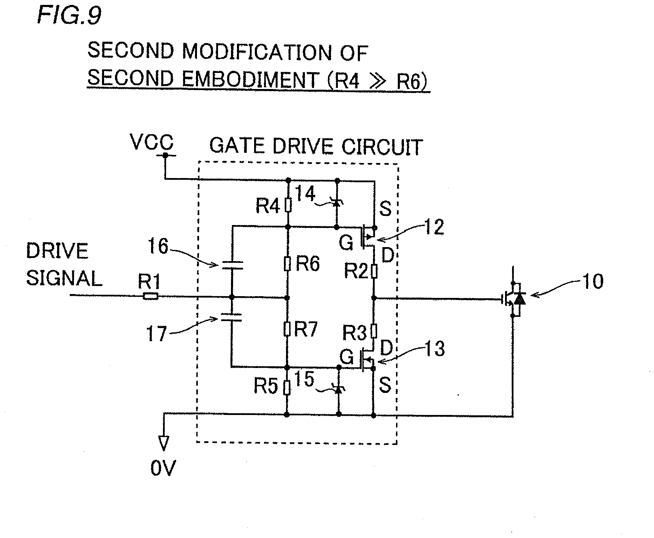

In addition, a second modification of the second embodiment is shown in Fig. 9. A difference from the second embodiment (Fig. 5) is that a Zener diode 14 is arranged between a power supply potential VCC and the gate (G) of a PchFET 12 while a Zener diode 15 is arranged between a ground potential (0 V) and the gate (G) of an NchFET 13, as shown in Fig. 9. The Zener voltage of the Zener diode 14 (or the Zener diode 15) is set to be higher than the threshold voltage of the PchFET 12 (or the NchFET 13). In order to maintain a voltage between the gate and the source of the PchFET 12 (or the NchFET 13) at the Zener voltage when the PchFET 12 (or the NchFET 13) is on, a resistance R6 (R6 « R4) is provided in parallel with a condenser 16 while a resistance R7 (R7 « R5) is provided in parallel with a condenser 17. The resistance values of the resistances R4 and R5 are substantially equal to each other. The resistance values of the resistances R6 and R7 are smaller than the resistance values of the resistances R4 and R5 by one or more orders of magnitude. Thus, a current flowing into the resistance R6 when the PchFET 12 is on partially flows into the Zener diode 14, and hence the voltage between the gate and the source of the PchFET 12 is maintained at the Zener voltage. The same applies to the NcFET 13.

In the case of the second modification of the second embodiment, the Zener voltage of the Zener diode 14 is applied to the gate (G) of the PchFET 12 (the gate voltage of the PchFET 12 is suppressed by the Zener voltage) when the PchFET 12 is on, and the Zener voltage of the Zener diode 15 is applied to the gate (G) of the NchFET 13 (the gate voltage of the NchFET 13 is suppressed by the Zener voltage) when the NchFET 13 is on. Similarly to the operation described in the second embodiment, the voltages applied to the PchFET 12 and the NchFET 13 reach the threshold voltage faster than the voltages applied to the PchFET 112 and the NchFET 113 according to the comparative example when an ON-state is switched to an OFF-state. Furthermore, the condenser 16 has a function of increasing the rate of increase in the voltage applied to the gate (G) of the PchFET 12 when the PchFET 12 shifts from the ON-state to the OFF-state while the condenser 17 has a function of increasing the rate of decrease in the voltage applied to the gate (G) of the NchFET 13 when the NchFET 13 shifts from the ON-state to the OFF-state, and hence in view of this as well, the voltages applied to the PchFET 12 and the NchFET 13 reach the threshold voltage fast. Thus, this modification is different in circuit structure from the second embodiment as described above, but effects similar to those of the second embodiment are obtained.

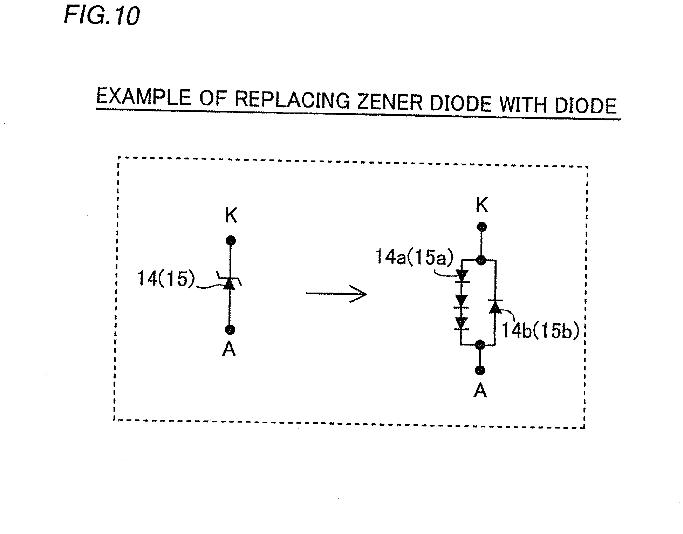

While the Zener diodes 14 and 15 are employed to shift the voltages applied to the gates (G) of the PchFET 12 and the NchFET 13 to the sides of the threshold voltages of the gates (G) of the PchFET 12 and the NchFET 13, as described above, in the first embodiment (Fig. 2), the second embodiment (Fig. 5), the first modification of the second embodiment (Fig. 8), and the second modification of the second embodiment (Fig. 9), the present invention is not restricted to this. These Zener diodes each may alternatively be replaced with a circuit constituted by diodes shown in Fig. 10, for example. When normal diodes are employed, the forward drop voltages of the diodes are substituted for a voltage corresponding to a Zener voltage (breakdown voltage), and in order to obtain a voltage whose magnitude is equal to that of the Zener voltage, one or more (three in Fig. 10) diodes 14a (15a) are connected in series, as shown in Fig. 10. Furthermore, in order to obtain a substitution for forward characteristics of each Zener diode, one diode 14b (15b) is connected in antiparallel with this series connector of one or more diodes 14a (15a).

As described above, the series connector having one or more diodes 14a (15a) so connected in series that diode forward drop voltages are substantially equal to the breakdown voltage of each Zener diode and a parallel connector having one diode 14b (15b) in a polarity opposite to that of the series connector, connected in parallel therewith are prepared. Then, each Zener diode is replaced with the parallel connector such that the cathode (K) of each Zener diode is the cathode of the diode in the opposite polarity while the anode (A) of each Zener diode is the anode of the diode in the opposite polarity.

**Claims**

1. A gate drive circuit (11, 11a, 11b) driving a gate of a switching element (9), comprising:

    a P-type field effect transistor (12);
    an N-type field effect transistor (13) connected in series with said P-type field effect transistor; and
    a diode (14, 15) connected to at least either a gate of said P-type field effect transistor or a gate of said N-type field effect transistor and connected to a power source, wherein
    said diode is so formed as to shift a voltage applied to at least either said gate of said P-type field effect transistor or said gate of said N-type field effect transistor to a side of a threshold voltage of at least either said gate of said P-type field effect transistor or said gate of said N-type field effect transistor.

2. The gate drive circuit according to claim 1,
    wherein
    said diode includes a Zener diode (14, 15) to shift said voltage applied to at least either said gate of said P-type field effect transistor or said gate of said N-type field effect transistor to said side of said threshold voltage of at least either said gate of said P-type field effect transistor or said gate of said N-type field effect transistor.

3. The gate drive circuit according to claim 2,
    wherein
    said Zener diode includes a first Zener diode (14) to shift a voltage applied to said gate of said P-type field effect transistor to a side of a threshold voltage of said gate of said P-type field effect transistor by increasing said voltage applied to said gate of said P-type field effect transistor and a second Zener diode (15) to shift a voltage applied to said gate of said N-type field effect transistor to a side of a threshold voltage of said gate of said N-type field effect transistor by decreasing said voltage applied to said gate of said N-type field effect transistor.

4. The gate drive circuit according to claim 3,
    wherein
    a total voltage obtained by adding a threshold voltage of said P-type field effect transistor, a breakdown voltage of said first Zener diode, a breakdown voltage of said second Zener diode, and a threshold voltage of said N-type field effect transistor is not less than a voltage of said power source.

5. The gate drive circuit according to claim 3,
    wherein
    said first Zener diode is connected to an input side into which a signal driving said gate drive circuit is input, and a side of said first Zener diode opposite to said input side into which a signal driving said gate drive circuit is input and said gate of said P-type field effect transistor are connected to said power source.

**6.** The gate drive circuit according to claim 3,
wherein
said second Zener diode is connected to an input side into which a signal driving said gate drive circuit is input, and a side of said second Zener diode opposite to said input side into which a signal driving said gate drive circuit is input and said gate of said N-type field effect transistor are connected to a ground potential.

**7.** The gate drive circuit according to claim 1,
wherein
said diode includes a series connector (14a, 15a) having one or more diodes so connected in series that diode forward drop voltages are equal to a breakdown voltage of a Zener diode and a parallel connector (14b, 15b) having a diode in a polarity opposite to that of said series connector, connected in parallel with said series connector.

**8.** The gate drive circuit according to claim 1, further comprising a condenser (16, 17) provided in parallel with said diode between an input side into which a signal driving said gate drive circuit is input and at least either said gate of said P-type field effect transistor or said gate of said N-type field effect transistor.

**9.** The gate drive circuit according to claim 8,
wherein
said condenser includes a first condenser (16) to increase a rate of increase in a voltage applied to said gate of said P-type field effect transistor when said P-type field effect transistor shifts from an ON-state to an OFF-state and a second condenser (17) to increase a rate of decrease in a voltage applied to said gate of said N-type field effect transistor when said N-type field effect transistor shifts from an ON-state to an OFF-state.

**10.** The gate drive circuit according to claim 8, further comprising a discharging diode (18, 20) provided in parallel with said diode and said condenser between said input side into which a signal driving said gate drive circuit is input and at least either said gate of said P-type field effect transistor or said gate of said N-type field effect transistor.

**11.** The gate drive circuit according to claim 1,
wherein
said gate of said P-type field effect transistor and said gate of said N-type field effect transistor are connected to said power source or a ground potential through first resistances having resistance values equal to each other, second resistances having resistance values smaller than said resistance values of said first resistances by one or more orders of magnitude are arranged between an input side into which a signal driving said gate drive circuit is input and said gates of said P-type field effect transistor and said N-type field effect transistor, and said diode includes a Zener diode (14, 15) provided at least either between said gate and a source of said P-type field effect transistor or between said gate and a source of said N-type field effect transistor.

*FIG.1*

EP 2 560 282 A1

*FIG.2*

FIRST EMBODIMENT

## FIG.3

FIRST EMBODIMENT

DRIVE SIGNAL

A | B | C | D

GATE VOLTAGE
OF PchFET (12)
ACCORDING TO
FIRST EMBODIMENT

VCC
THRESHOLD
VOLTAGE
ZENER VOLTAGE
0V

GATE VOLTAGE
OF PchFET (112)
ACCORDING TO
COMPARATIVE
EXAMPLE

PchFET (12)   ON   OFF   ON

SIMULTANEOUS
ON-PERIOD

SIMULTANEOUS
ON-PERIOD
(COMPARATIVE
EXAMPLE)

SIMULTANEOUS ON-PERIOD
(COMPARATIVE EXAMPLE)

SIMULTANEOUS
ON-PERIOD

ZENER
VOLTAGE

VCC

GATE VOLTAGE
OF NchFET (113)
ACCORDING TO
COMPARATIVE EXAMPLE

THRESHOLD
VOLTAGE
0V

NchFET (13)   OFF   ON   OFF

SWITCHING
ELEMENT (9)   ON   OFF   ON

GATE VOLTAGE
OF NchFET (13)
ACCORDING TO
FIRST EMBODIMENT

16

*FIG.4*

COMPARATIVE EXAMPLE

*FIG.5*

SECOND EMBODIMENT

## FIG.6

### SECOND EMBODIMENT

## FIG.7

| | COMPARATIVE EXAMPLE | FIRST EMBODIMENT | SECOND EMBODIMENT |
|---|---|---|---|
| SIMULTANEOUS ON-PERIOD (L → H) | 105ns | 58ns | 15ns |
| SIMULTANEOUS ON-PERIOD (H → L) | 70ns | 0ns | 0ns |
| POWER CONSUMPTION | 0.27W | 0.09W | 0.02W |
| ON-DELAY | 13ns | 15ns | 15ns |
| OFF-DELAY | 65ns | 18ns | 18ns |
| THRESHOLD VOLTAGE OF PchFET | 1.7V | 1.7V | 1.7V |
| THRESHOLD VOLTAGE OF NchFET | 1.15V | 1.15V | 1.15V |
| RESISTANCE R1 | 130Ω | 130Ω | 130Ω |
| RESISTANCE R2 | 10Ω | 10Ω | 10Ω |
| RESISTANCE R3 | 1Ω | 1Ω | 1Ω |
| RESISTANCE R4 | | 10kΩ | 10kΩ |
| RESISTANCE R5 | | 10kΩ | 10kΩ |
| CONDENSER 16 | | | 220pF |
| CONDENSER 17 | | | 220pF |

## FIG.8

### FIRST MODIFICATION OF SECOND EMBODIMENT

*FIG.9*

## SECOND MODIFICATION OF
## SECOND EMBODIMENT (R4 ≫ R6)

*FIG.10*

EXAMPLE OF REPLACING ZENER DIODE WITH DIODE

## EUROPEAN SEARCH REPORT

Application Number

EP 12 15 6288

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | EP 0 447 989 A2 (SEIT ELETTRONICA SRL [IT]) 25 September 1991 (1991-09-25)<br>* figure 1 * | 1-10<br><br>11 | INV.<br>H03K17/0412 |
| Y<br><br>A | WO 2004/030212 A1 (DMB TECHNOLOGY CO LTD [KR]; RYOO TAE-HA [KR]; JANG BYUNG-TAK [KR]) 8 April 2004 (2004-04-08)<br>* page 6, line 25 - page 9, line 20; figures 3,4 * | 11<br><br>1-10 | |
| X | US 5 910 746 A (FORDYCE GRAHAM THOMAS [US]) 8 June 1999 (1999-06-08)<br>* column 4, line 43 - column 7, line 60; figure 4 * | 1-3,11 | |
| A | US 7 660 137 B1 (GOINS LAWRENCE W [US] ET AL) 9 February 2010 (2010-02-09)<br>* column 3, line 4 - column 5, line 59; figure 2 * | 1-11 | |
| A | US 4 672 521 A (RIESCO LUIS A [US]) 9 June 1987 (1987-06-09)<br>* column 3, line 42 - column 7, line 2; figures 4,6 * | 1 | TECHNICAL FIELDS SEARCHED (IPC)<br><br>H03K |
| A | "HIGH PERFORMANCE TOTEM-POLE DRIVE", IBM TECHNICAL DISCLOSURE BULLETIN, INTERNATIONAL BUSINESS MACHINES CORP. (THORNWOOD), US, vol. 31, no. 10, 1 March 1989 (1989-03-01), pages 304-306, XP000098801, ISSN: 0018-8689<br>* figure 1 * | 1 | |

The present search report has been drawn up for all claims

| Place of search | Date of completion of the search | Examiner |
|---|---|---|
| Munich | 3 August 2012 | Moll, Peter |

EPO FORM 1503 03.82 (P04C01)

# EP 2 560 282 A1

## ANNEX TO THE EUROPEAN SEARCH REPORT
## ON EUROPEAN PATENT APPLICATION NO.

EP 12 15 6288

This annex lists the patent family members relating to the patent documents cited in the above-mentioned European search report.
The members are as contained in the European Patent Office EDP file on
The European Patent Office is in no way liable for these particulars which are merely given for the purpose of information.

03-08-2012

| Patent document cited in search report | | Publication date | Patent family member(s) | | | Publication date |
|---|---|---|---|---|---|---|
| EP 0447989 | A2 | 25-09-1991 | AT | 126409 | T | 15-08-1995 |
| | | | DE | 69111860 | D1 | 14-09-1995 |
| | | | DE | 69111860 | T2 | 21-12-1995 |
| | | | EP | 0447989 | A2 | 25-09-1991 |
| | | | IT | 1240906 | B | 20-12-1993 |
| WO 2004030212 | A1 | 08-04-2004 | AU | 2003267839 | A1 | 19-04-2004 |
| | | | JP | 2006501718 | A | 12-01-2006 |
| | | | KR | 20040028256 | A | 03-04-2004 |
| | | | US | 2005269631 | A1 | 08-12-2005 |
| | | | WO | 2004030212 | A1 | 08-04-2004 |
| US 5910746 | A | 08-06-1999 | NONE | | | |
| US 7660137 | B1 | 09-02-2010 | US | 7660137 | B1 | 09-02-2010 |
| | | | US | 2010135047 | A1 | 03-06-2010 |
| US 4672521 | A | 09-06-1987 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2006340088 A